# EUROPÄISCHE PATENTANMELDUNG

(11) **EP 2 061 295 A2**
(43) Veröffentlichungstag der Anmeldung: **20.05.2009**
(21) Anmeldenummer: 08019582.9
(22) Anmeldetag: 10.11.2008
(51) Int. Cl.: H05K 7/20

(54) **Installationsschrank zur Aufnahme von elektrischen oder elektronischen Geräten, insbesondere von Recheneinrichtungen, sowie Einrichtung umfassend mehrere solcher Installationsschränke, und Verfahren zum Betreiben einer solchen Einrichtung**

(30) Priorität: 14.11.2007 DE 102007054724
(71) Anmelder: KKT KRAUS Kälte- und Klimatechnik GmbH, 91207 Lauf (DE)
(72) Erfinder: Haßler, Hans, J., 90765 Fürth (DE)
(74) Vertreter: Blaumeier, Jörg

(57) **Zusammenfassung**

Installationsschrank zur Aufnahme von elektrischen oder elektronischen Geräten, insbesondere von Recheneinrichtungen, der allseits sowie über eine Tür geschlossen ist und eine, Kühleinrichtung zur Kühlung der Innenluft aufweist oder dem eine solche zugeordnet ist, wobei die Kühleinrichtung (7) zwei separate Kreise (A, B) bildende, gewunden geführte und ineinander verwobene Kühlmittelleitungen (18) aufweist, die mit separaten, jeweils einem eigenständigen Kühlmittelkreislauf (I, II) zugeordneten Kühlmittelzu- und -ableitungen (14, 15) verbindbar sind.

## Beschreibung

Die Erfindung betrifft einen Installationsschrank zur Aufnahme von elektrischen oder elektronischen Geräten, insbesondere von Recheneinrichtungen, der allseits sowie über wenigstens eine, gegebenenfalls eine vordere und eine hintere Tür geschlossen ist und eine Kühleinrichtung zur Kühlung der Innenluft aufweist oder dem eine solche zugeordnet ist.

Derartige Installationsschränke kommen beispielsweise in größeren Rechenzentren zum Einsatz und dienen der Aufnahme elektrischer oder elektronischer Geräte, insbesondere jedoch von Recheneinrichtungen. Die Recheneinrichtungen werden im Schrank an einer entsprechenden Gestellhalterung übereinander angeordnet. Im Hinblick auf die immer größer werdende Rechenleistung, die ein solches Rechenzentrum zu vollziehen hat, werden immer leistungsfähigere Recheneinrichtungen verwendet, so dass die pro Installationsschrank installierte Rechenleistung immer weiter zunimmt. Dies geht einher mit einer immer weiter steigenden Aufnahme elektrischer Leistung. In Zukunft werden Recheneinrichtungen mit einer elektrischen Leistungsaufnahme von mehr als 10 kW, bis hin zu 20 kW und mehr, pro Schrank installiert werden. Nachdem ein Großteil der aufgenommenen elektrischen Energie in Wärme umgewandelt wird, ist für eine ausreichende Kühlung zu sorgen, um zu verhindern, dass die Recheneinrichtungen aufgrund zu geringer Wärmeabfuhr überhitzen. Dabei besteht das Problem, dass es bedingt durch die extrem hohe Leistungsaufnahme im Falle eines Defekts der Kühlung innerhalb weniger Sekunden zu einem Ausfall der Recheneinrichtungen aufgrund von Überhitzung kommt. Um für eine ausreichende Kühlung zu sorgen, kommt deshalb eine Kühleinrichtung zum Einsatz, die den Innenraum kühlt. Eine solche Kühleinrichtung wird in Form eines Luftkühlers verwendet, der mit Wasser oder einem Wasser-Frostschutz-Gemisch oder anderen Flüssigkeiten als Kühlmittel versorgt wird, das durch entsprechende Kühlmittelleitungen der Kühleinrichtung zirkuliert. Der Kühleinrichtung ist eine Umlufteinrichtung zugeordnet, über die die Luft im Schrankinneren umgewälzt wird, so dass sie durch die Kühleinrichtung strömt, wobei sie gekühlt wird, und anschließend an den zu kühlenden Recheneinrichtungen vorbei und zurück zur Kühleinrichtung gezogen wird. Unter Verwendung einer solchen Kühleinrichtung ist es möglich, eine ausreichende Kühlung zu erreichen. Bei Ausfall der Kühleinrichtung ist jedoch sofort zu reagieren, um eine Beschädigung der Recheneinrichtungen zu vermeiden. Hierfür ist ein Temperaturwächter vorgesehen, der die Innenraumtemperatur erfasst und bei Ausfall der Kühlung für ein kontrolliertes Herunterfahren der Recheneinrichtungen sorgt. Der damit verbundene Ausfall dieser Recheneinrichtungen bis zum erneuten Hochfahren ist jedoch mit hohen Ausfallkosten verbunden und deshalb wenn irgendwie möglich zu vermeiden.

Der Erfindung liegt damit das Problem zugrunde, einen Installationsschrank anzugeben, der sicherheitstechnisch im Falle eines Schadens an der Kühleinrichtung verbessert ist.

Zur Lösung dieses Problems ist bei einem Installationsschrank der eingangs genannten Art vorgesehen, dass die Kühleinrichtung zwei separate Kreise bildende, gewunden geführte und ineinander verwobene Kühlmittelleitungen aufweist, die mit separaten, jeweils einem eigenständigen Kühlmittelkreislauf zugeordneten Kühlmittelzu- und -ableitungen verbindbar sind.

Die Erfindung schlägt einen Installationsschrank mit einer Zwei-Kreis-Kühleinrichtung vor, wobei die beiden Kreise ineinander verwoben sind. Jeder Kreis besteht aus einer oder mehreren gewunden geführten Kühlmittelleitungen, wobei die Kühlmittelleitungen der einzelnen Kreise quasi ineinandergreifen bzw. miteinander verwoben sind, so dass sich insgesamt eine kompakte Bauform der Kühleinrichtung ergibt. Jeder Kreis kann mit den Kühlmittelzu- und -ableitungen zweier separat betreibbarer, eigenständiger Kühlmittelkreisläufe verbunden werden. Dies bietet nun die Möglichkeit, den Installationsschrank hochsicher kühlen zu können, denn bei einem Defekt in einem Kreis der Kühleinrichtung oder in einem Zu- oder Ablauf des Kühlmittelkreislaufs kann gezielt dieser Kühlmittelkreislauf aus dem Netz genommen werden, während der andere Kühlmittelkreislauf nach wie vor die volle Kühlleistung zur Verfügung stellen kann. Kommt es also im einen Kreis zu einem Defekt, also z.B. einem Leck, so kann der Kühlmittelfluss in diesem sofort gestoppt werden, ohne dass dies in irgend einer Weise einen Einfluss auf die Kühlung der Recheneinrichtungen hätte, die von nun an zu 100% von dem anderen Kühlmittelkreislauf bzw. Kreis der Kühleinrichtung übernommen wird. Diese redundante Kühlung stellt nun in höchstem Maße eine kontinuierliche Kühlung der Recheneinrichtungen sicher, so dass bei Ausfall eines Teils der Kühlung und dem kontinuierlichen, insbesondere über eine USV sichergestellten Betrieb der Recheneinrichtungen stets die volle Kühlleistung über den anderen Systemteil zur Verfügung steht.

Eine konkrete Ausgestaltung einer kompakt aufgebauten Kühleinrichtung kann derart sein, dass jeder Kreis einen mit der Kühlmittelzuleitung verbindbaren Zulaufverteiler und einen mit der Kühlmittelableitung verbindbaren Rücklaufverteiler aufweist, wobei sich jede Kühlmittelleitung von dem Zulaufverteiler zum Rücklaufverteiler in einer U-förmigen Schleife erstreckt, und die einander entgegengerichteten Schleifen der beiden Kreise ineinander greifen. Die Kühlmittelleitungen, die gegebenenfalls aufgezogene, seitlich abstehende Lamellen, z.B. aus Aluminium aufweisen können, laufen also quasi kammartig vom jeweiligen Zulaufverteiler zum jeweiligen Rücklaufverteiler, die beide an der gleichen Seite der Kühleinrichtung angeordnet sind. Dies ermöglicht es, die Leitungsschleifen einander entgegengerichtet ineinander zu schieben, so dass sich insgesamt eine äußerst kompakte Bauform ergibt.

Neben dem Installationsschrank selbst betrifft die Erfindung ferner eine Einrichtung umfassend mehrere erfindungsgemäße Installationsschränke. Diese Einrichtung zeichnet sich dadurch aus, dass zwei separate, getrennt voneinander und parallel miteinander betreibbare Kühlmittelkreisläufe vorgesehen sind, wobei die Kühlmittelleitungen des einen Kreises aller Installationsschränke in den einen Kühlmittelkreislauf und die Kühlmittelleitungen des anderen Kreises aller Installationsschränke in den anderen Kühlmittelkreislauf integriert sind. Die Einrichtung weist also zwei eigenständig betreibbare Kühlmittelkreisläufe auf, wobei in den einen Kühlmittelkreislauf alle ersten Kreise aller Kühleinrichtungen sämtlicher Schränke integriert sind, also von diesem gespeist werden, während die zweiten Kreise aller Kühleinrichtungen sämtlicher Installationsschränke in den zweiten Kühlmittelkreislauf, von diesem gespeist, integriert sind. Die Einrichtung verfügt selbstverständlich über eine geeignete Leckageerfassung, die jedem Kühlmittelkreislauf zugeordnet ist, vornehmlich über eine geeignete Drucksensorik, die den Kühlmitteldruck in der Zu- und Rücklaufleitung erfasst. Sobald die Leckageerfassung eines Kühlmittelkreislaufs ein Leck detektiert, wird dieser Kühlmittelkreislauf abgeschaltet, das heißt, die jeweiligen Kreise der Kühleinrichtungen in den Installationsschränken werden nicht mehr mit Kühlmittel versorgt. Die 100%-ige Zurverfügungstellung der Kühlleistung wird nunmehr durch den anderen Kühlmittelkreislauf zur Verfügung gestellt. Als Kühlmittel wird bevorzugt Wasser verwendet.

Wenngleich grundsätzlich die Möglichkeit besteht, den zweiten Kühlmittelkreislauf erst dann zu betreiben, wenn tatsächlich ein Leck im ersten Kühlmittelkreislauf erfasst wurde, was bei nur sehr wenigen integrierten Installationsschränken und sehr kurzen Leitungslängen grundsätzlich möglich wäre, da in diesem Fall das Kühlmittel noch hinreichend schnell im zweiten Kühlmittelkreislauf umgepumpt werden und mithin die Kühlung einsetzen kann, ist es vor allem bei größeren Einrichtungen zweckmäßig, beide Kühlmittelkreisläufe stets parallel miteinander zu betreiben, und zwar derart, dass jeder Kühlmittelkreislauf die pro Installationsschrank benötigte Kühlleistung zu jeweils 100% zur Verfügung stellt. Jeder Kühlmittelkreislauf wird also so betrieben, als wenn er allein die volle Kühlleistung pro Installationsschrank zur Verfügung stellen müsste, das heißt, die Wassermenge bzw. der Durchfluss in jeder Kühleinrichtung bzw. in jedem Kreislauf ist stets 100%. In jedem Installationsschrank werden jedem Kreis der Kühleinrichtung aber nur 50% der Kühlleistung entzogen, das heißt, jeder Kreis wird nur mit 50% seiner Maximalkapazität belastet. Fällt jedoch ein Kreis aus, weil ein Kühlmittelkreislauf defekt ist, so stehen sofort die 100% des anderen Kühlmittelkreislaufs zur Verfügung, der nunmehr zu 100% belastet wird. Es kommt folglich zu keinem Zeitpunkt zu einer Einschränkung der Kühlung, mithin kann über dieses hochsichere Kühlungssystem zu jedem Zeitpunkt der volle Betrieb der Recheneinrichtungen sichergestellt werden.

Jedem Kreislauf ist eine eigene Kühlmitteleinspeisung zugeordnet. Hierüber wird sichergestellt, dass immer ein Kreis voll funktionsfähig ist, sollte der andere abgeschaltet werden, da die kreiseigene Einspeisung unabhängig von der Einspeisung des anderen, abgeschalteten Kreises arbeitet.

Zweckmäßigerweise ist jeweils eine Steuerungseinrichtung für jeden der beiden Kreisläufe vorgesehen, die bei einem Leck in einer Kühlmittelleitung einer Kühleinrichtung oder einer Kühlmittelzu- oder -ableitung die Zufuhr von Kühlmittel über den jeweiligen Kühlmittelkreislauf, in den die leckende Kühlmittelleitung integriert oder Teil dessen die Kühlmittelzu- oder-ableitung ist, über ein Sperrmittel stoppt. Die Ansteuerung des Sperrmittels erfolgt unmittelbar nach der Erfassung eines Lecks über die Leckageerfassungseinrichtung, gegebenenfalls nach Plausibilisierungsprüfung des Erfassungsergebnisses. Hierüber wird vermieden, dass infolge eines Weiterbetriebs des Kühlmittelkreislaufs bis zu einem späteren Stopp kontinuierlich Kühlmittel, hier also vornehmlich Wasser, austritt, was zu anderweitigen Schäden führen kann. Vielmehr ist die maximale Kühlmittelmenge, die austreten kann, auf das Volumen beschränkt, das sich noch im Kühlmittelkreislauf zwischen dem Sperrmittel im Zu- und Ablauf befindet. Beide Steuerungseinrichtungen arbeiten selbständig, so dass stets die volle Funktionsfähigkeit jedes der Kreisläufe gewährleistet ist. Gegebenenfalls kommunizieren beide Steuerungseinrichtungen miteinander, um im Falle eines Lecks Informationen auszutauschen, sofern dies erforderlich sein sollte.

Weiterhin kann in jedem Kreislauf eine die Kühlmittelleitungen und die Kühlmittelableitungen eines Primärkreises von denen eines Sekundärkreises trennende Trenneinrichtung vorgesehen sein, über die der Fluss des Kühlmittels vom Primärkreis zum Sekundärkreis sperrbar ist. Jeder Kreislauf ist also in eine Primär- und einen Sekundärkreislauf ausgeteilt, die beide über eine Trenneinrichtung, die das oben beschriebene Spreemittel bildet, verbunden sind. Bei einer solchen Trenneinrichtung kann es sich z.B. um einen Plattenwärmetauscher handeln. Die Trenneinrichtungen stehen vorzugsweise außerhalb des Raumes, in dem die Installationsschränke angeordnet sind. Diese Trenneinrichtung, die im Falle eines Wärmetauschers auch für eine Temperierung des Kühlmittels im Zulauf und im Ablauf zuständig ist, verfügt über geeignete Elektromagnetventile, über die die jeweilige Leitung sofort geschlossen werden kann.

Ferner kann in jedem Installationsschrank wenigstens eine Leckerfassungseinrichtung und in jedem Kreislauf wenigstens eine weitere Leckerfassungseinrichtung vorgesehen sein, wobei die schrankseitige Leckerfassungseinrichtung mit jeder der Steuerungseinrichtungen kommuniziert und die kreislaufeigenen weiteren Leckerfassungseinrichtungen mit der jeweiligen kreislaufeigenen Steuerungseinrichtung kommuniziert. Über die schrankseitigen Leckerfassungseinrichtungen kann unmittelbar in jedem Schrank sofort ein Leck erfasst werden. Die Auflösung, welcher Kreislauf von dem Leck betroffen ist, erfolgt über die weiteren Leckerfassungseinrichtungen dem beiden Kreisläufe, die z.B. als Drucksensoren ausgebildet sind. Wird über einen solchen Sensor ein Druckabfall in einem der Kreisläufe erfasst, was auf ein Leck hinweist, und wird über das Signal eines der schrankseitigen Lecksensoren dieses Erfassungsergebnis verifiziert oder plausibilisiert, so ist der entsprechende Kreislauf abzuschalten. Dies erfolgt auch, wenn das Leck nicht in einem Installationsschrank gegeben ist, sondern im Bereich der Zu- und Ableitungen. Dann wird nur über die kreislaufeigenen Leckerfassungseinrichtungen ein Leckagesignal erfasst, nicht aber über die schrankseitigen Sensoren. Es kommt gleichwohl zum Abschalten des Kreislaufs. In dem der Druckabfall erfasst wurde,

Das Kühlmittel selbst ist bevorzugt Wasser, die Erfindung ist jedoch hierauf nicht beschränkt.

Weiterhin betrifft die Erfindung ferner ein Verfahren zum Betreiben einer solchen Einrichtung in Form einen Rechenzentrums, umfassend mehrere mit Recheneinrichtungen belegte Installationsschränke, deren Kühleinrichtungen in zwei separat und parallel betriebene Kühlmittelkreisläufe integriert sind, wobei im Normalbetrieb die pro Installationsschrank benötigte Kühlleistung zu jeweils 100% von jedem der beiden Kühlmittelkreisläufe zur Verfügung gestellt wird, und wobei bei Erfassung einer Störung der Kühlmittelzu- oder -abfuhr in einem Kühlmittelkreislauf, insbesondere eines Lecks in einer Kühlmittelleitung einer beliebigen integrierten Kühleinrichtung oder einer Kühlmittelzu- oder -ableitung, der Kühlmittelfluss in diesem Kühlmittelkreislauf gestoppt wird und die Zufuhr von Kühlmittel ausschließlich über den anderen Kreislauf unter gleichbleibender Bereitstellung von 100% der benötigten Kühlleistung erfolgt. Als Kühlmittel wird bevorzugt Wasser verwendet.

Weitere Vorteile, Merkmale und Einzelheiten der Erfindung ergeben sich aus dem im folgenden beschriebenen Ausführungsbeispiel sowie anhand der Zeichnungen. Dabei zeigen:
- Fig. 1: eine Prinzipdarstellung eines erfindungsgemäßen Installationsschranks in einer Seitenansicht,
- Fig. 2: den Installationsschrank aus Fig. 1 in einer Fronansicht,
- Fig. 3: eine Prinzipdarstellung einer Kühleinrichtung mit zwei separaten Kühlkreisen, und
- Fig. 4: eine Prinzipdarstellung einer erfindungsgemäßen Einrichtung.

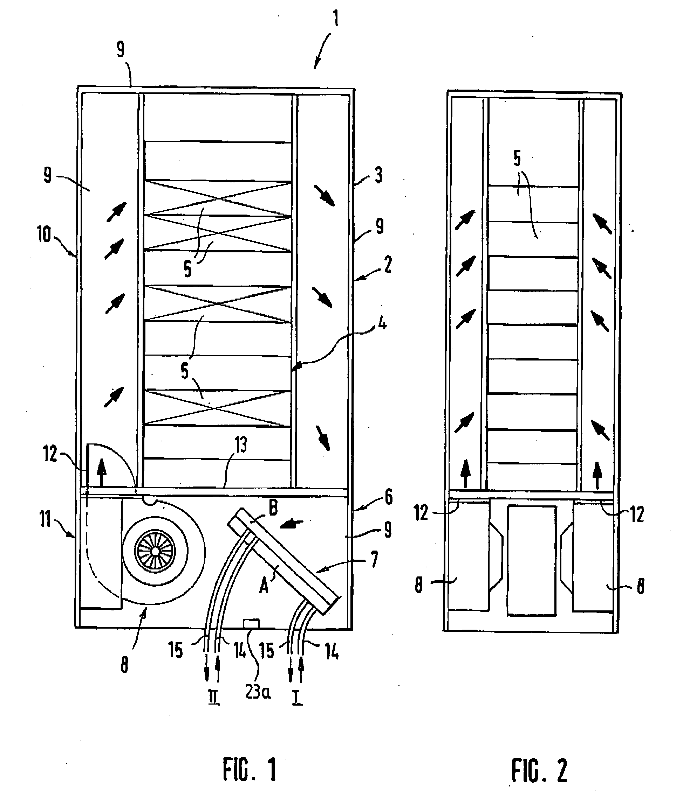

Fig. 1 zeigt einen erfindungsgemäßen Installationsschrank 1, bestehend aus einem oberen Schrankteil 2, bestehend aus einem Rahmengestell 3, in dem ein weiteres Gestell 4 integriert ist, in das wiederum eine Vielzahl einzelner Geräte, hier Recheneinrichtungen 5, in an sich bekannter Weise eingeschoben werden können. Der Installationsschrank 1 umfasst ferner ein unteres Teil 6, in dem eine Kühleinrichtung 7 sowie zwei separate drehzahlgeregelte Ventilatoren 8 angeordnet sind. Sowohl das obere Schrankteil 2 als auch das untere Schrankteil 6 sind seitlich geschlossen, wozu entsprechende Wandelemente 9 vorgesehen sind, die hier nur zum Teil gezeigt sind. Frontseitig ist jeweils eine Tür 10 bzw. 11 vorgesehen, die den Zugang zum Inneren des jeweiligen Schrankteils 2, 6 ermöglicht. Über die beiden Ventilatoren wird Luft über eine oder mehrere Rückschlagklappen 12, die im Zwischenboden 13 zwischen den beiden Schrankteilen 2, 6 angeordnet sind, wie durch den Pfeil dargestellt an der Vorderseite, also im Bereich der Schranktür 10, nach oben vor die Recheneinrichtung 5 geblasen. Wie durch die weiteren Pfeile dargestellt, strömt die Luft an den Recheneinrichtungen vorbei in den Bereich hinter den Recheneinrichtungen 5, wo sie aufgrund des Ventilatorbetriebs an der Rückseite wieder nach unten strömt und durch eine weitere Öffnung im Zwischenboden 13 vor die Kühleinrichtung 7 gezogen wird. Sie durchströmt die Kühleinrichtung 7 und wird von den Ventilatoren 8 wieder vor die Recheneinrichtungen 5 gefördert, so dass sie insgesamt eine Zirkulation ergibt. Während der Passage durch die Kühleinrichtung 7 wird die Luft gekühlt, das heißt, die beim Vorbeiströmen an den Recheneinrichtungen 5 aufgenommene und abgeführte Wärme wird an die Kühleinrichtung bzw. das dort zirkulierende Kühlmittel abgegeben, so dass hinter der Kühleinrichtung 7 gekühlte Luft von den Ventilatoren 8 vor die Recheneinrichtungen 5 gefördert werden kann. Wie Fig. 2 zeigt, sind die beiden Ventilatoren 8 an den Seiten des Schrankteils 6 angeordnet, ebenso die beiden Rückschlagklappen 11, so dass ersichtlich die Luft, wie durch die Pfeile in Fig. 2 gezeigt ist, auch von der Seite her die Recheneinrichtungen 5 umströmt.

Wie in der Prinzipdarstellung in Fig. 1 gezeigt, sind an der Kühleinrichtung 7 zwei separate Kreise, in denen das Kühlmittel durch die Kühleinrichtung 7 strömen kann, realisiert, nämlich ein Kreis A und ein Kreis B, die in Fig. 1 der Übersichtlichkeit halber optisch getrennt als separate Abschnitte der Kühleinrichtung 7 gezeigt sind. Jeder Kreis A, B verfügt über separate Kühlmittelleitungen, worauf nachfolgend noch eingegangen wird, und ist mit jeweils einer Kühlmittelzufuhrleitung 14 und einer Kühlmittelableitung 15 verbunden, die jeweils unterschiedlichen Kühlmittelkreisläufen I und II zugeordnet sind. Das heißt, jede der separaten Kühleinrichtungskreise A und B ist einem separaten Kühlmittelkreislauf I der II zugeordnet. Im gezeigten Beispiel wird der Kreis A vom Kühlmittelkreislauf 1 und der Kreis B vom Kühlmittelkreislauf II versorgt.

Gezeigt ist ferner eine schrankseitige Leckerfassungseinrichtung 23a, z.B. ein Wassersensor, der, worauf nachfolgend noch eingegangen wird, mit jeweiligen Steuerungseinrichtungen der beiden Kreise A und B kommuniziert. Über diesen Sensor kann sich im Installationsschrank im Falle eines Lecks ansammelndes Wasser sofort und unter Erfassung des betroffenen Schranks erfasst werden.

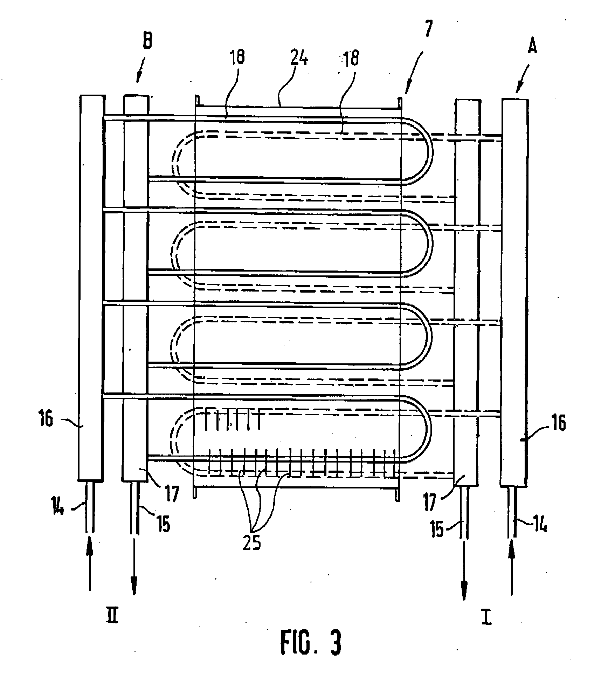

Der prinzipielle Aufbau der Kühleinrichtung 7 ist in Fig. 3 dargestellt. Jede Kühlmittelzuleitung 14 mündet in einen Zulaufverteiler 16, jede Kühlmittelableitung 15 ist mit einem Rücklaufverteiler 17 verbunden. Von den jeweiligen Zulaufverteilern 16 erstrecken sich eine Vielzahl einzelner Kühlmittelleitungen 18 mit aufgezogenen, radial abstehenden metallenen Lamellen 25 z.B. aus Aluminium in einer U-förmigen Schleifenform zum jeweils zugeordneten Rücklaufverteiler 17. Während in Fig. 3 aus Übersichtlichkeitsgründen der Zulaufverteiler 16 und der Rücklaufverteiler 17 nebeneinander angeordnet sind, sind diese tatsächlich bevorzugt übereinander angeordnet. Die beiden Kreise A und B sind in Fig. 3 gezeigt, wobei die Kühlmittelleitungen 18 des Kreises A der Übersichtlichkeit halber gestrichelt gezeigt sind, während die Kühlmittelleitungen 18 des Kreises B ausgezogen dargestellt sind. Infolge der Anordnung der Zulauf- und Rücklaufverteiler 16, 17 übereinander stehen folglich die einzelnen Kühlmittelleiterschleifen leicht schräg, so dass sich insgesamt eine ineinander greifende, verwobene Struktur ergibt, das heißt, die Kühlmittelleitungen 18 des Kreises A sind in die ebenfalls kammartig verlaufenden, entgegengesetzt gerichteten Kühlmittelleitungen 18 des Kreises B gesteckt. Wenngleich Fig. 3 letztlich nur eine Ebene an Kühlmittelleitungen 18 zeigt, ist es selbstverständlich denkbar, auch mehrere solcher Ebenen in der Kühleinrichtung vorzusehen, wobei den Kühlmittelleitungen des jeweiligen Kreises A oder B jeweils gemeinsame Zulauf- und Rücklauferteiler oder jeweils separate Zulauf- und Rücklaufverteiler zugeordnet sind, die wiederum untereinander gekoppelt und mit den Kühlmittelzu- und -ableitungen 14, 15 verbunden sind. Die Kühleinrichtung weist einen rahmen 24 auf, an dem die Kühlmittelzu- und - ableitungen 14, 15 fixiert sind.

In jedem Fall weist die Kühleinrichtung eine verwobene Struktur auf, innerhalb welcher die Kühlmittelleitungen der beiden separaten Kreise A und B in kompakter Weise eng benachbart ineinander geschoben vorgesehen sind.

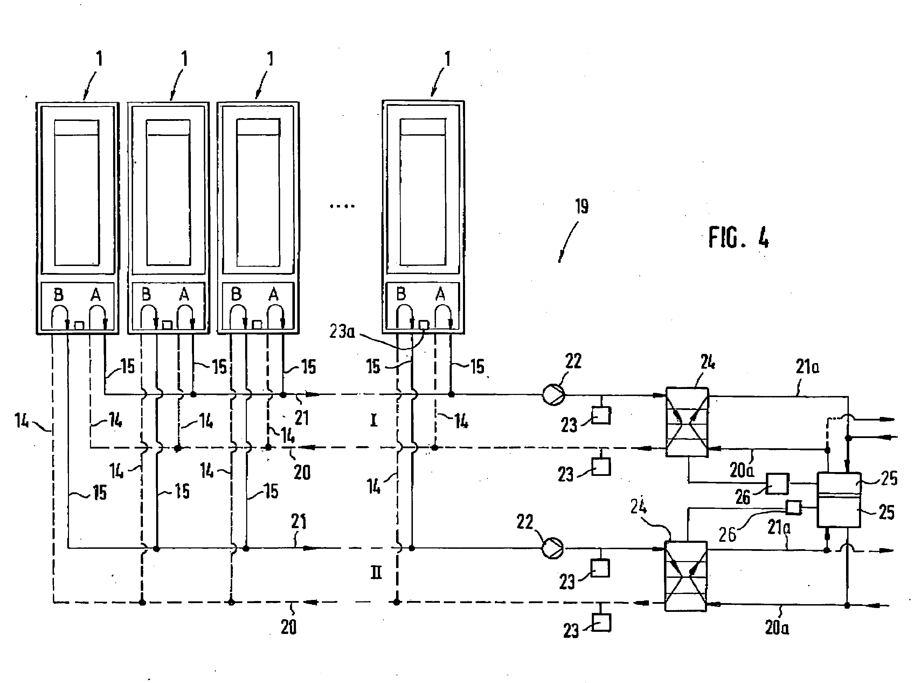

Die Verwendung eines solchen Zwei-Kreis-Kühlers 7 ermöglicht es, ein komplett neues Einrichtungskonzept zu realisieren, wie es dem Grunde nach in Fig. 4 gezeigt ist. Fig. 4 ist ein Prinzipschema, in dem nur die für die Erläuterung der Erfindung nötigen Komponenten gezeigt sind. Tatsächlich sind eine Vielzahl von Ventilen und Verbindungs- oder Kommunikationsleitungen etc. vorgesehen, die hier der Übersichtlichkeit halber nicht gezeigt sind. Gezeigt ist eine erfindungsgemäße Einrichtung 19, umfassend eine Vielzahl von Installationsschränken 1, die mit einer Vielzahl separater Recheneinrichtungen, hier nicht näher gezeigt, bestückt sind. Beispielsweise nimmt die installierte Rechnerkapazität jedes Installationsschranks eine elektrische Leistung von 20 kW auf, so dass allein von den Rechnern her rührend eine Wärmeleistung von näherungsweise ebenfalls rund 20 kW kühltechnisch zu verarbeiten ist, wobei noch etwaige Wärme, die von den Ventilatoren 8 und etwaigen Schalt- und Steuerteilen, die zum Betrieb der Ventilatoren und gegebenenfalls weiteren installierten elektrischen oder elektronischen Gerätschaften dienen, abzuführen ist.

Wie bereits bezüglich Fig. 1 beschrieben, sind bei der erfindungsgemäßen Einrichtung 19 zwei separate Kühlmittelkreise 1 und 11 realisiert. Jeder der Kühlmittelkreise I, II verfügt über eine zentrale Kühlmittelzuleitung 20 sowie über eine zentrale Kühlmittelrückleitung 21. Von den Zuleitungen 20 zweigen die jeweiligen Kühlmittelzuleitungen 14 und die Kühlmittelableitungen 15 der jeweiligen Kreise A und B ab und führen zu den entsprechenden Zulaufverteilern 16 bzw. von den Rücklaufverteilern 17 wieder zurück. In Fig. 4 sind die einzelnen Kühleinrichtungen 7 in den Installationsschränken 1 nicht näher gezeigt, es ist lediglich dem Grunde nach der Rückfluss über die gebogenen Pfeile wie auch die einzelnen Kreise A und B dargestellt. Zur Förderung des Wassers, das hier das Kühlmittel bildet, weist jeder Kühlmittelkreislauf I, II eine Pumpe 22 auf, die in der jeweiligen Rücklaufleitung 21 angeordnet ist. Ferner ist jeder der Leitungen 20, 21 und damit jedem Kreislauf I, II eine weitere Leckerfassungseinrichtung 23 zugeordnet, im gezeigten Beispiel entsprechende Drucksensoren, über die ein etwaiger Druckabfall in jeder der Leitungen 20, 21 bzw. den mit ihnen verbundenen Leitungen 14, 15 erfasst werden kann. Wie bereits ausgeführt, ist auch in jedem Installationsschrank eine Leckerfassungseinrichtung 23a vorgesehen. Vorgesehen ist ferner in jedem der Kreisläufe I, II eine diesen Einrichtungen nachgeschaltete Trenneinrichtung 24 (z.B. ein Plattenwärmetauscherapparat), über die jeder Kreislauf I, II in einen Primärkreislauf mit den der Kaltwasserzufuhr dienenden Zu- und Ableitungen 20a, 21 a und einen Sekundärkreislauf mit den zu den Schränken führenden Zu- und Ableitungen 20, 21 getrennt wird. Jede Trenneinrichtung 24 hat die zum einen die Funktion hat, das ihr aus einer im jeweiligen Primärkreis jedes Kreises I, II angeordneten Wassereinspeisung 25 über die jeweilige Zuleitung 20a zugeführte Wasser, das eine Vorlauftemperatur von beispielsweise +8°C hat, auf eine Mindesttemperatur von beispielsweise +12°C zu erwärmen, sowie das über die Rücklaufleitung 21 von den Installationsschränken 1 zurückströmende, erwärmte Wasser, das beispielsweise eine Temperatur von +15°C hat, zu kühlen, beispielsweise auf +12°C, welches Wasser im Primärkreis sodann wieder an die jeweilige kreiseigene Einspeisung 25 zurückläuft und dort weiter gekühlt wird bzw. im Sekundärkreis über die jeweiligen Zuleitungen 20 wieder zu den Installationsschränken zurückgeführt wird. Die beiden Einspeisung 25, die separat voneinander arbeiten, sind hier nur prinzipiell dargestellt.

Eine weitere Funktion der Trennstationen 24 ist, im Falle eines erfassten Lecks innerhalb eines der Kühlmittelkreise I, II diesen umgehend zu sperren, so dass in dem jeweiligen Kreislauf kein weiteres Wasser mehr zirkuliert. Sie wirkt also als Sperrmittel. Jeder Einspeisung 25 ist eine separate, kreislaufeigene Steuerungseinrichtung 26 zugeordnet, über die der Betrieb der Einspeisung 25 bzw. der Betrieb des jeweiligen Kreislaufs gesteuert wird. Die weiteren Leckerfassungseinrichtungen 23, die jeweils einem Kreislauf zugeordnet sind, kommuniziert mit der jeweiligen Steuerungseinrichtung 26. Sobald die Leckerfassungseinrichtungen 23 einen Druckabfall im jeweiligen Kreis I oder II detektieren, wird dies an eine jeweilige Steuerungseinrichtung 26, die den gesamten Betrieb des jeweiligen Kühlmittelkreislaufs I bzw. II sowie der entsprechenden Komponenten, steuert, gegeben. Dieses steuert wiederum die jeweilige Trenneinrichtungen 24 des betroffenen Kreislaufs I bzw. II an, gegebenenfalls auch die zentrale Einspeisung 25, so dass die jeweilige Trenneinrichtung 24, die dem leckenden Kreislauf I oder II zugeordnet ist, diesen sofort sperrt, wozu sie entsprechende Ventile aufweiset, die geschlossen werden können, oder wozu über sie an anderen Orten im jeweiligen Kreislauf befindliche Ventile ansteuert.

Ein Leck in einem der Schränke kann über die dort vorgesehene Leckerfassungseinrichtung 23a erfasst werden. Diese Leckerfassungseinrichtungen kommunizieren mit beiden Steuerungseinrichtungen. Wird also in einem Schrank ein Leck erfasst, so wird ein entsprechendes Signal an beide Steuerungseinrichtungen gegeben. Diese Signale können eine Information darüber enthalten, welche Leckerfassungseinrichtung 23a das Signal sendet bzw. welcher Installationsschrank betroffen ist, um gegebenenfalls sofort vor Ort nach Abschalten des Kreislaufs Gegenmaßnahmen ergreifen zu können. Um aufzulösen, welcher der beiden Kreisläufe I, II betroffen ist und abgeschaltete werden muss, wird das jeweilige Signal der weiteren Leckerfassungseinrichtungen 23 von beiden Steuerungseinrichtungen 26 ausgewertet. Im Falle eines Lecks im Kreislauf I detektiert die z.B. als Drucksensor ausgebildete Leckerfassungseinrichtung 23 einen Druckabfall, die Steuerungseinrichtung des Kreislaufs I erhält ein entsprechendes Alarmsignal. Über diese wird nun verifiziert, dass das von den Lecksensor 23a im Schrank erfasste Leck im Kreislauf I gegeben ist, dar daraufhin über die Steuerungseinrichtung 26 sofort abgeschaltet wird. Die Leckerfassungseinrichtung 23 des Kreislaufs II erfasst kein Leck bzw. keine Druckabfall, an der Steuerungseinrichtung 26 des Kreislaufs II liegt nach wie vor ein kein Leck anzeigendes Signal an. Infolgedessen registriert die Steuerungseinrichtung 26 des Kreislaufs II zwar, dass im betroffenen Schrank ein Leck gegeben ist, ordnet dieses aber nicht dem von ihr gesteuerten Kreislauf zu. Vielmehr arbeitet sie bzw. ihr Kreislauf zu 100% weiter wie bisher.

Im Normalbetrieb werden die beiden Kühlmittelkreisläufe I, II parallel zu jeweils 100% betrieben, das heißt, in beiden Kreisläufen I, II zirkuliert stets die Wassermenge mit der jeweiligen Vorlauftemperatur, die benötigt wird, um die 100% Wärmeleistung, die in jedem Installationsschrank 1 anfällt und abzuführen ist, auch tatsächlich mit jeweils nur einem Kühlmittelkreis I oder II abführen zu können. Theoretisch stehen also an Kühlleistung 200% zur Verfügung, jeweils 100% von jeweils einem Kühlmittelkreislauf. Im Betrieb wird jeder Kühlmittelkreislauf nur zu jeweils 50% belastet, stellt also nur 50% der tatsächlich benötigten Kühlleistung zur Verfügung, nachdem die zu kühlende, von den Recheneinrichtungen erhitzte Luft gleichförmig an den Kühlmittelleitungen 18 beider Kreise A und B vorbeiströmt. Ausgehend von einer Vorlauftemperatur von +12°C beträgt die Rücklauftemperatur in beiden Kreisläufen I und II z.B. +15°C, pro Kreislauf ist also ein ΔT von 3°C gegeben.

Kommt es nun zur Leckerfassung, und wird beispielsweise der Kühlmittelkreislauf I abgeschaltet, so hat dies aufgrund des redundant vorgesehenen Kühlmittelkreislaufs II keinerlei Auswirkungen auf den Kühlbetrieb. Denn vom Kühlmittelkreislauf II stehen ohnehin 100% Kühlleistung zur Verfügung, die nunmehr vollständig ausgenutzt werden, um die im Schrank anfallende warme Luft zu kühlen. Das heißt, dass der Ausfall eines der Kühlmittelkreisläufe I oder II lediglich dazu führt, dass der andere, kontinuierlich weiterarbeitende Kühlmittelkreislauf nunmehr vollständig belastet wird, die Kühlung der Recheneinrichtungen in den jeweiligen Installationsschränken erfährt jedoch keinerlei Einschränkung. Die Rücklauftemperatur beträgt dann gemäß obigem Beispiel +18°C, das ΔT in diesem einen dann voll belasteten Kreislauf folglich +6°C. Die Abschaltung des leckenden Kühlmittelkreislaufs ermöglicht nun die Lecksuche und Reparatur desselben, wonach der Kühlmittelkreislauf wieder angefahren werden kann, mithin also wieder dazugeschaltet werden kann, ohne dass der nach wie vor betriebene andere Kühlmittelkreislauf in irgendeiner Form hiervon tangiert oder anderweitig geregelt werden müsste. Beide liefern sodann wieder 100% Kühlleistung, ausgelegt auf die in den Installationsschränken abzuführende Wärmeleistung und werden wieder parallel betrieben.

## Patentansprüche

1. Installationsschrank zur Aufnahme von elektrischen oder elektronischen Geräten, insbesondere von Recheneinrichtungen, der allseits sowie über wenigstens eine Tür geschlossen ist und eine Kühleinrichtung zur Kühlung der Innenluft aufweist oder dem eine solche zugeordnet ist, **dadurch gekennzeichnet, dass** die Kühleinrichtung (7) zwei separate Kreise (A, B) bildende, gewunden geführte und ineinander verwobene Kühlmittelleitungen (18) aufweist, die mit separaten, jeweils einem eigenständigen Kühlmittelkreislauf (I, II) zugeordneten Kühlmittelzu- und -ableitungen (14, 15) verbindbar sind.

2. Installationsschrank nach Anspruch 1, **dadurch gekennzeichnet, dass** jeder Kreis (A, B) einen mit der Kühlmittelzuleitung (14) verbindbaren Zulaufverteiler (16) und einen mit der Kühlmittelableitung (15) verbindbaren Rücklaufverteiler (17) aufweist, wobei sich jede Kühlmittelleitung (18) von dem Zulaufverteiler (16) zum Rücklaufverteiler (17) in einer U-förmigen Schleife erstreckt, und die einander entgegengerichteten Schleifen der beiden Kreise ineinander greifen.

3. Einrichtung umfassend mehrere Installationsschränke nach Anspruch 1 oder 2, sowie zwei separate, getrennt voneinander und parallel miteinander betreibbare Kühlmittelkreisläufe (I, II), wobei die Kühlmittelleitungen (18) des einen Kreises (A) aller Kühleinrichtungen (7) der Installationsschränke (1) in den einen Kühlmittelkreislauf (I) und die Kühlmittelleitungen (18) des anderen Kreises (B) aller Kühleinrichtungen (7) der Installationsschränke (1) in den anderen Kühlmittelkreislauf (II) integriert sind.

4. Einrichtung nach Anspruch 3, **dadurch gekennzeichnet, dass** die beiden Kühlmittelkreisläufe (I, II) derart betreibbar sind, dass jeder Kühlmittelkreislauf (I, II) die pro Installationsschrank (1) benötigte Kühlleistung zu 100% zur Verfügung stellt.

5. Einrichtung nach Anspruch 4, **dadurch gekennzeichnet, dass** jedem Kreislauf (I, II) eine eigene Kühlmitteleinspeisung (25) zugeordnet ist.

6. Einrichtung nach einem der Ansprüche 3 bis 5, **dadurch gekennzeichnet, dass** jeweils eine Steuerungseinrichtung (26) für jeden der beiden Kreisläufe (I, II) vorgesehen ist, die bei einem Leck in einer Kühlmittelleftung (18) einer Kühleinrichtung (7) oder einer Kühlmittelzu- oder -ableitung (14, 15, 21, 21) die Zufuhr von Kühlmittel über den jeweiligen Kühlmittelkreislauf (I, II) über ein Sperrmittel (24) stoppt.

7. Einrichtung nach Anspruch 6, **dadurch gekennzeichnet, dass** in jedem Kühlmittelkreislauf (I, II) eine die Kohlmittelzuleitungen und die Kühlmittelableitungen eines Primärkreises von denen eines Sekundärkreis trennende Trenneinrichtung (24) vorgesehen ist, über die der Fluss des Kühlmittels vom Primärkreis zum Sekundärkreis sperrbar ist.

8. Einrichtung nach einem der vorangehenden Ansprüche, **dadurch gekennzeichnet, dass** in jedem Installationsschrank wenigstens eine Leckerfassungseinrichtung und in jedem Kreislauf wenigstens eine weitere Leckerfassungseinrichtung vorgesehen ist, wobei die schrankseitigen Leckerfassungseinrichtung mit jeder der Steuerungseinrichtungen und die kreislaufeigenen weiteren Leckerfassungseinrichtungen mit der kreislaufeigenne Steuerungseinrichtung kommunizieren.

9. Einrichtung nach einem der Ansprüche 3 bis 8, **dadurch gekennzeichnet, dass** das Kühlmittel Wasser ist.

10. Verfahren zum Betreiben einer Einrichtung nach einem der Ansprüche 3 bis 9 in Form eines Rechenzentrums, umfassend mehrere mit Recheneinrichtungen (5) belegte Installationsschränke (1), deren Kühleinrichtungen (7) in zwei separat und parallel betriebene Kühlmittelkreisläufe (I, 11) integriert sind, wobei im Normalbetrieb die pro Installationsschrank (1) benötigte Kühlleistung zu je 100% von jedem der beiden Kühlmittelkreisläufe (I, II) zur Verfügung gestellt wird, und wobei bei Erfassung einer Störung der Kühlmittelzu- oder -abfuhr in einem Kühlmittelkreislauf (I, II), insbesondere eines Lecks in einer Kühlmittelleitung (18) einer beliebigen integrierten Kühleinrichtung (7) oder einer Kühlmittelzu- oder -ableitung (14, 15, 20, 21), der Kühlmittelfluss in diesem Kühlmittelkreislauf (I, II) gestoppt wird und die Zufuhr von Kühlmittel ausschließlich über den anderen Kühlmittelkreislauf (I, II) unter gleichbleibender Bereitstellung von 100% der benötigten Kühlleistung erfolgt.

11. Verfahren nach Anspruch 10, **dadurch gekennzeichnet, dass** als Kühlmittel Wasser verwendet wird.
